# EUROPÄISCHE PATENTSCHRIFT

(11) **EP 1 115 921 B1**
(45) Veröffentlichungstag und Bekanntmachung des Hinweises auf die Patenterteilung: **08.10.2003**
(21) Anmeldenummer: 99955788.7
(22) Anmeldetag: 20.09.1999
(51) Int. Cl.: C30B 29/06

(54) **VERFAHREN ZUR ERZEUGUNG EINER AMORPHEN ODER POLYKRISTALLINEN SCHICHT AUF EINEM ISOLATORGEBIET**
METHOD FOR PRODUCING AN AMORPHOUS OR POLYCRYSTALLINE LAYER ON AN INSULATING REGION
PROCEDE DE PRODUCTION D'UNE COUCHE AMORPHE OU POLYCRISTALLINE SUR UNE REGION D'ISOLATION

(30) Priorität: 21.09.1998 DE 19845792
(43) Veröffentlichungstag der Anmeldung: 18.07.2001
(73) Patentinhaber: IHP GmbH-Innovations for High Performance Microelectronics/Institut für innovative Mikroelektronik, 15236 Frankfurt an der Oder (DE)
(72) Erfinder: TILLACK, Bernd, D-15234 Frankfurt (Oder) (DE); HEINEMANN, Bernd, D-15234 Frankfurt(Oder) (DE); KNOLL, Dieter, D-15230 Frankfurt (Oder) (DE); EHWALD, Karl-Ernst, D-15234 Frankfurt (Oder) (DE); WOLANSKY, Dirk, D-15234 Frankfurt (Oder) (DE)
(74) Vertreter: Eisenführ, Speiser & Partner
(86) Internationale Anmeldenummer: DE9903069
(87) Internationale Veröffentlichungsnummer: WO00017423

(56) Entgegenhaltungen:
- EP-A- 0 241 316
- US-A- 4 221 044
- US-A- 4 396 933
- PATENT ABSTRACTS OF JAPAN vol. 012, no. 207 (E-621), 14. Juni 1988 (1988-06-14) & JP 63 006874 A (FUJITSU LTD), 12. Januar 1988 (1988-01-12) -& JP 63 006874 A (FUJITSU LTD) 12. Januar 1988 (1988-01-12)
- PATENT ABSTRACTS OF JAPAN vol. 011, no. 217 (E-523), 14. Juli 1987 (1987-07-14) & JP 62 036865 A (FUJITSU LTD), 17. Februar 1987 (1987-02-17) -& JP 62 036865 A (FUJITSU LTD) 17. Februar 1987 (1987-02-17)
- PATENT ABSTRACTS OF JAPAN vol. 013, no. 468 (E-834), 23. Oktober 1989 (1989-10-23) & JP 01 183114 A (FUJITSU LTD), 20. Juli 1989 (1989-07-20) -& JP 01 183114 A (FUJITSU LTD) 20. Juli 1989 (1989-07-20)
- DATABASE INSPEC [Online] INSTITUTE OF ELECTRICAL ENGINEERS, GB ZHENG QI-JING ET AL: "Nucleation and early stage growth of polycrystalline silicon deposition" Database accession no. 1983545 XP002130790 & JOURNAL OF NANJING INSTITUTE OF TECHNOLOGY, 1982, CHINA, Nr. 2, Seiten 91-104, ISSN: 0254-4180
- RYUM B R ET AL: "MBE-GROWN SIGE BASE HBT WITH POLYSILICON-EMITTER AND TISI2 BASE OHMIC LAYER" SOLID STATE ELECTRONICS, Bd. 39, Nr. 11, 1. November 1996 (1996-11-01), Seiten 1643-1648, XP000635613 ISSN: 0038-1101

## Beschreibung

Die Erfindung bezieht sich auf ein Verfahren zur Erzeugung einer amorphen oder polykristallinen Schicht auf einem Isolatorgebiet.

Amorphe oder polykristalline Schichten werden in der Halbleitertechnik in verschiedensten Bereichen eingesetzt. Ein wichtiges Einsatzgebiet derartiger Schichten sind vertikale Bipolartransistoren für Hochgeschwindigkeitsanwendungen, die nach einer Einfach-Poly-Silizium-Technologie mit epitaktisch eingebrachten Basisschichten hergestellt werden. Bedingt durch die schlechte Bekeimung der üblicherweise verwendeten SiO₂-Schicht als Isolatorschicht, ist die amorphe oder polykristalline Schicht aus Silizium in der Regel dünner als eine epitaktisch gewachsene Schicht. Zusätzlich wird durch die schlechte und ungleichmäßige Bekeimung der SiO₂-Schicht eine homogene Abscheidung erschwert. Im Falle von polykristallinem Silizium entstehen unterschiedlich große Körner, die außerdem eine raue Oberfläche und ungleichmäßige elektrische Eigenschaften bedingen.

Bezüglich der Epitaxieschichtdicke ergeben sich zwei unterschiedliche Forderungen. Innerhalb des Emitterbereiches sollte eine hinreichend geringe Schichtdicke zwischen dem hochdotierten Emitter und der Basis vorhanden sein. Im äußeren Basisgebiet ist eine größere Dicke von Vorteil, um geringe Widerstände des Basisanschlusses zu ermöglichen.

Insbesondere offenbaren PATENT ABSTRACTS OF JAPAN vol. 012, no. 207 (E-621), 14. Jun 1988 (1988-06-14) & JP 63006874 A (FUJITSU LTD), 12. Januar 1988 (1988-01-12) und PATENT ABSTRACTS OF JAPAN vol. 011, no. 217 (E-523), 14. Juli 1987 (1987-07-14) & JP 62036865 A (FUJTTSU LTD), 17. Februar 1987 (1988-01-12). Halbleiterbauelemente, die ein Substrat, eine SiO₂ Schicht, eine Si₃N₄ Schicht auf der SiO₂ Schicht, eine polykristalline Siliziumschicht auf der Si₃N₄ Schicht und eine, gleichzeitig mit der polykristallinen Siliziumschicht aufgebrachte, epitaktische Siliziumschicht auf dem Substrat enthalten.

Aufgabe der Erfindung ist es, ein Verfahren zur Erzeugung einer amorphen oder polykristallinen SiGe Schicht auf einem Isolatorgebiet vorzuschlagen, bei dem gegenüber bisherigen Verfahren die Dicke der amorphen oder polykristallinen Schicht größer, die Homogenität der Abscheidung verbessert und damit die Oberflächenrauhigkeit reduziert wird. Dabei sollen die isolierenden Eigenschaften des Isolatorgebietes mindestens beibehalten werden.

Erfindungsgemäß wird diese Aufgabe dadurch gelöst, daß durch Aufbringen einer geeigneten Siliziumnitrid- Ankeimschicht mit gutem Bekeimungvermögen und isolierenden Eigenschaften auf dem Isolatorgebiet, die Bekeimung bei der Abscheidung der amorphen oder polykristallinen Schicht verbessert wird. Dadurch ist die Dicke der amorphen oder polykristallinen Schicht wesentlich größer als bei Weglassen der Ankeimschicht. Die größere Dicke der amorphen oder polykristallinen Schicht wird durch eine bessere Bekeimung erreicht, die eine Verkürzung der Induktionsperiode (Totzeit) für die Abscheidung auf der Isolatorschicht bewirkt. Die bessere und gleichmäßigere Bekeimung der Ankeimschicht verursacht eine homogene Abscheidung. Es entstehen Schichten mit gleichmäßiger Komstruktur und geringer Oberflächenrauhigkeit. Dadurch werden gleichmäßige elektrische Eigenschaften erreicht.
Besonders eignet sich die Verwendung einer SiO_{z}-Schicht als Isolatorschicht.

Die Merkmale der Erfindung gehen außer aus den Ansprüchen auch aus der Beschreibung und den Zeichnungen hervor, wobei die einzelnen Merkmale jeweils für sich allein oder zu mehreren in Form von Unterkombinationen schutzfähige Ausführungen darstellen, für die hier Schutz beansprucht wird. Ausführungsbeispiele der Erfindung sind in den Zeichnungen dargestellt und werden im folgenden näher erläutert.
Die Zeichnungen zeigen:
- Fig. 1: Schematische Darstellung eines Bipolartransistors,
- Fig. 2: Schematische Darstellung eines Bipolartransistors nach Fig. 1 während der Herstellung,
- Fig. 3: Schematische Darstellung eines Schichtaufbaus vor der Epitaxie und
- Fig. 4: Schematische Darstellung eines Schichtaufbaus nach der Epitaxie.

### Beispiel 1:

Die Erfindung wird nun im Zusammenhang mit einem Einfach-Poly-Silizium-Prozeß mit epitaktisch erzeugter Basis beschrieben.

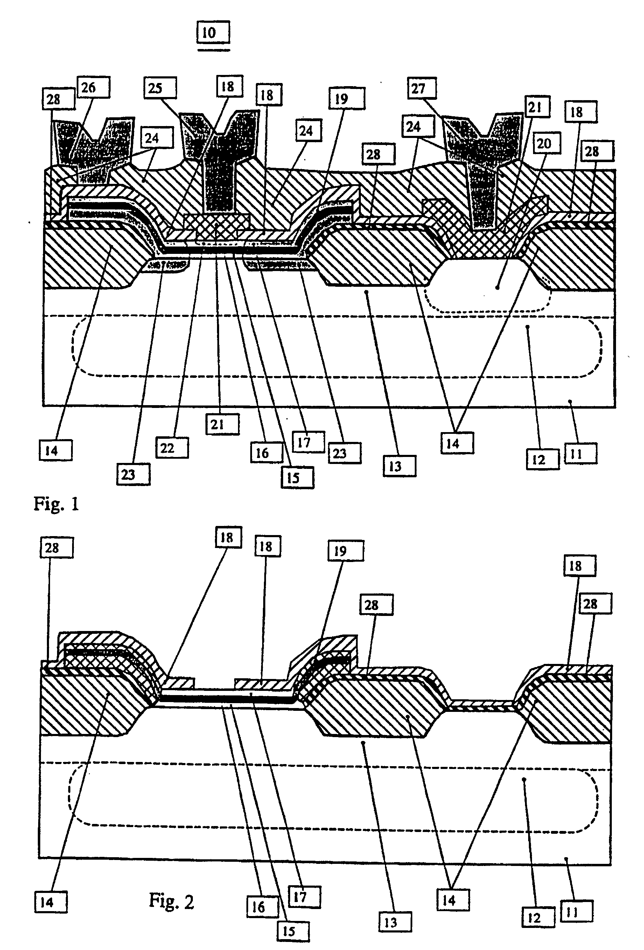

Fig. 1 zeigt schematisch einen Bipolartransistor **10**. Auf dem halbleitenden Substratgebiet **11** vom Leitfähigkeitstyp I ist ein Kollektorgebiet vom Leitfähigkeitstyp II erzeugt worden. Sind Emitter und Kollektor z. B. n-leitend, ist die Basis vom p-Typ bzw. umgekehrt. Es sind mehrere Verfahren bekannt, die eine geeignete Kollektordotierung liefern. Dazu zählen zum Beispiel der in Fig. 1 gezeigte Aufbau mit einer hochdotierten, vergrabenen Schicht **12** und einer schwächer dotierten Epitaxieschicht **13**, aber auch implantierte retrograde Wannen. Feldisolationsgebiet **14** trennt im hier dargestellten Beispiel den Bipolartransistor von anderen, in der Fig. nicht dargestellten Bauelementen und auch den Kollektoranschlußbereich vom aktiven Transistorgebiet. Es sind auch andere geeignete Isolationstechniken bekannt, wie z. B. verspacerte Mesa-Anordnungen. Ein Schachtimplant **20** ist in diesem Ausführungsbeipiel eingesetzt worden, um den Widerstand zwischen der aus hochdotiertem Poly-Silizium bestehenden Kontaktschicht **21** und der vergrabenen Schicht **12** zu verringern. Auf dem Isolationsgebiet befindet sich erfindungsgemäß eine Schicht mit sehr gutem Bekeimungsvermögen und isolierenden Eigenschaften (Ankeimschicht) **28**. In diesem Ausführungsbeispiel wird dafür Siliziumnitrid verwendet.
Eine Epitaxieschichtfolge, bestehend aus Pufferschicht **15**, in-situ dotierter Basisschicht **16** vom Leitfähigkeitstyp I sowie aus der Deckelschicht **17,** bedeckt die Emitterregion im aktiven Transistorbereich und mindestens einen Teil des Isolationsgebietes, versehen mit der Ankeimschicht **28.** Die außerhalb des aktiven Transistorgebietes strukturierte Epitaxieschicht ist mit einem Dielektrikum **18** bedeckt.
Als wesentlich im Sinne der Erfindung ist die Verwendung einer dicken polykristallinen Schicht auf dem Isolatorgebiet anzusehen. Die speziellen Werte für die Dicke, den Dotandengehalt sowie die Materialzusammensetzung der Basis sind entsprechend den Erfordernissen der Funktion des Bipolartransistors einzustellen und unterliegen bezüglich dem Wesen der Erfindung keinen besonderen Anforderungen. Im dargestellten Beispiel besteht die Basisschicht aus Silizium, ist mit 2.10¹⁸ cm⁻³ p-dotiert und sei 40 nm dick. Es können aber auch andere Materialkompositionen und Dotierungsprofile verwendet werden. Der Einsatz einer dünnen Deckelschicht **17** über der Basisschicht ist möglich. Die Dotierung des Emitters im einkristallinen Silizium wird durch Ausdiffusion von Dotierstoff **22** aus der hochdotierten Poly-Silizium-Kontaktschicht **21** sichergestellt. Die abgeschiedene Dicke der Deckelschicht **17** beträgt typischerweise 50 nm. Während die Puffer-, Basis- und Deckelschicht einkristallin über dem Silizium-Substrat wachsen, entstehen polykristalline Schichten **19** über dem mit der Ankeimschicht **28** versehenen Isolationsgebiet **14**. Durch die Verwendung der Ankeimschicht 28 wird die Dicke der abgeschiedenen polykristallinen Schicht erfindungsgemäß vergrößert. Außerhalb der den aktiven Transistorbereich überlappenden Poly-Silizium-Kontaktschicht **21** ist die Dotierung im Basisanschlußgebiet zusätzlich durch Implantation **23** vergrößert worden. Die Isolationsschicht **24** trennt Emitter-, Basis- und Kollektorkontakt. Vervollständigt wird der Transistoraufbau durch Metallkontakte für Emitter **25**, Basis **26** und Kollektor **27**.
Im folgenden wird die Herstellung eines Bipolartransistors gemäß der Erfindung dargelegt. Ausgangspunkt für das erfindungsgemäße Verfahren ist der in Fig. 2 dargestellte Aufbau. In p-dotiertes Silizium-Substrat **11** wird nach photolithographischer Strukturierung eine hochdotierte n-Schicht **12** per Implantation eingebracht und ausgeheilt. Anschließend wird epitaktisch eine schwach dotierte n-Schicht **13** abgeschieden. Übliche Prozeßschritte definieren das aktive Gebiet und erzeugen in den verbleibenden Gebieten Isolationsgebiete **14** (z. B. LOCOS). Danach wird erfindungsgemäß ganzflächig eine Ankeimschicht **28** abgeschieden und über dem aktiven Transistorgebiet geöffnet. Vorzugsweise wird für die Ankeimschicht **28** Siliziumnitrid verwendet. Mit Hilfe der differentiellen Epitaxie wird die Pufferschicht **15**, die Basisschicht **16** und die Deckelschicht **17** abgeschieden. Durch die Verwendung der Ankeimschicht **28** wird die Bekeimung im Isolatorgebiet verbessert. Dadurch wird die Totzeit für die Abscheidung auf dem Isolatorgebiet reduziert. Als Resultat ist die polykristalline Schicht **19** auf dem Isolator wesentlich dicker als bei der Abscheidung ohne Verwendung der Ankeimschicht **28**.
Nach photolithographischer Strukturierung einer Maske werden mit Hilfe eines Plasmaätzschuttes außerhalb des späteren Transistor- und Basisanschlußgebietes die abgeschiedenen Silizium- bzw. Poly-Silizium-Schichten mit Ätzstopp auf dem Isolationsgebiet **14** entfernt. Anschließend wird ein Dielektrikum **18**, vorzugsweise Oxid, aufgebracht.
Durch photolithographische Strukturierung einer Lackmaske wird nun das Kollektoranschlußgebiet freigelegt und der Schachtimplant **20** eingebracht. Nach dem Entfernen dieser Lackmaske und der Strukturierung einer weiteren Lackmaske wird im Kollektoranschlußgebiet wie auch im Emitterbereich die Oxidschicht **18** naßchemisch geätzt. Der Prozeß wird fortgesetzt mit der Abscheidung einer amorphen Siliziumschicht. Diese kann bereits in-situ während oder im Anschluß an die Abscheidung durch Implantation dotiert werden. Mit einem Lithographieschritt werden Emitter- und Kollektorkontaktgebiet maskiert. In den übrigen Gebieten wird das amorphe Silizium bei einem Plasmaätzschritt mit Stopp auf der SiO₂-Schicht entfernt. Bei der anschließenden Implantation der Basisanschlußgebiete werden Emitter- und Kollektorkontaktbereich durch die vorhandene Maskierung geschützt. Nach Entfernen der Maskierung und Abdeckung der entstandenen Oberfläche mit Oxid folgt eine Temperung zur Ausheilung der Implantationsschäden sowie zur Formierung des Poly-Emitters. Der Prozeß wird vervollständigt durch das Öffnen der Kontaktlöcher für Emitter, Basis und Kollektor und eine Standardmetallisierung für die Transistorkontakte.

### Beispiel 2:

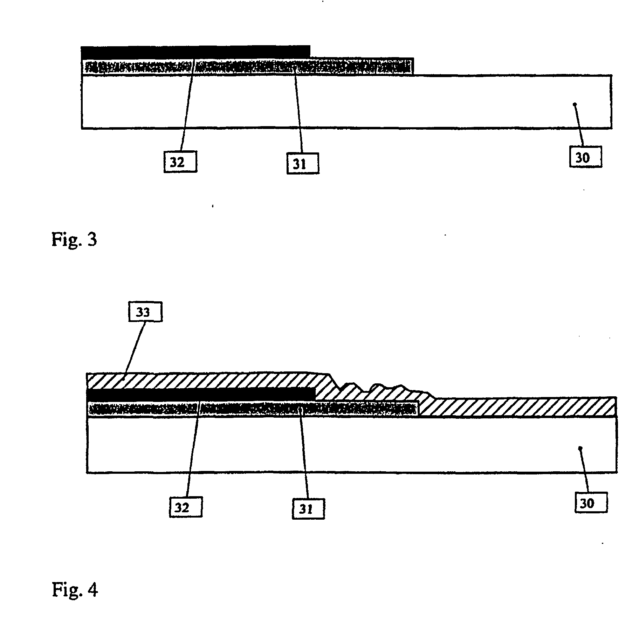

Ausgangspunkt für das erfindungsgemäße Verfahren ist in diesem Ausführungsbeispiel der in Fig. 3 dargestellte Schichtaufbau vor der Epitaxie. Auf Silizium-Substrat **30** ist eine aus SiO₂ bestehende Isolatorschicht **31** abgeschieden und mit Hilfe photolithographischer Prozesse strukturiert worden. Außerdem wird erfindungsgemäß die Isolatorschicht **31** teilweise durch eine strukturierte, aus Siliziumnitrid bestehende Ankeimschicht **32** bedeckt. Im Ergebnis des Epitaxieschrittes, dargestellt in Fig. 4, entsteht auf unbedecktem Siliziumsubstrat eine einkristalline Schicht. Die auf Isolatorschicht **31** und Ankeimschicht **32** gewachsenen polykristallinen Siliziumschichten **33** unterscheiden sich in Struktur und Dicke. Im Vergleich zur polykristallinen Schicht **33** auf der Isolatorschicht **31** besitzt die auf der Ankeimschicht **32** befindliche polykristalline Schicht **33** eine homogenere, feinkörnigere Struktur größerer Dicke.

In der vorliegenden Erfindung wurde anhand konkreter Ausführungsbeispiele ein Verfahren zur Erzeugung einer amorphen oder polykristallinen Schicht auf einem Isolatorgebiet erläutert. Es sei aber vermerkt, daß die vorliegende Erfindung nicht auf die Einzelheiten der Beschreibung in den Ausführungsbeispielen eingeschränkt ist, da im Rahmen der Patentansprüche Änderungen und Abwandlungen beansprucht werden.

## Patentansprüche

1. Verfahren zum Erzeugen einer amorphen oder polykristallinen Halbleiterschicht auf einem Isolatorgebiet (14, 31), bei dem zum Verbessern der Bekeimung auf dem Isolatorgebiet (14, 31) eine Siliziumnitridschicht (28, 32) erzeugt wird, durch die bei einer Abscheidung amorpher oder polykristalliner Schichten (19, 33) die Dicke wesentlich größer, die Homogenität der Abscheidung verbessert, die Korngrößenverteilung bei polykristallinen Schichten gleichmäßiger und die Oberflächenrauhigkeit geringer ist als bei Weglassen der Ankeimschicht (28, 32), **dadurch gekennzeichnet, dass** als Halbleiterschicht eine amorphe oder polykristalline Siliziumgermaniumschicht erzeugt wird.

2. Verfahren nach Anspruch 1, **dadurch gekennzeichnet, dass** die amorphe oder polykristalline Siliziumgermaniumschicht (19, 33) Kohlenstoff oder Sauerstoff als diffusionshemmendes Mittel enthält.

3. Verfahren nach Anspruch 1 oder 2, **dadurch gekennzeichnet, dass** die Siliziumnitridschicht (28, 32) vor einer differenziellen Epitaxie aufgebracht wird und damit die amorphe oder polykristalline Siliziumgermaniumschicht (19, 33) auf dem Isotatorgebiet (14, 31) und eine epitaktische Schicht auf dem einkristallinen Substrat (11, 30) entstehen.

## Claims

1. A process for producing an amorphous or polycrystalline semiconductor layer on an insulator area (14, 31), with which to improve the seeding on the insulator area (14, 31) a silicon nitride layer (28, 32) is produced, by which with a deposition of amorphous or polycrystalline layers (19, 33) the thickness is substantially larger, the homogeneity of the deposition [is] improved, the particle size distribution with polycrystalline layers is more uniform and the surface roughness is less than when the seeding layer (28, 32) is omitted,
**characterised in that** an amorphous or polycrystalline silicon germanium layer is produced as the semiconductor layer.

2. A process according to Claim 1,
**characterised in that** the amorphous or polycrystalline silicon germanium layer (19, 33) contains carbon or oxygen as diffusion-inhibiting means.

3. A process according to Claim 1 or 2,
**characterised in that** the silicon nitride layer (28, 32) is applied prior to a differential epitaxy and thus the amorphous or polycrystalline silicon germanium layer (19, 33) on the insulator area (14, 31) and an epitaxial layer on the monocrystalline substrate (11, 30) are produced.

## Revendications

1. Procédé pour la production d'une couche semi-conductrice amorphe ou polycristalline sur un domaine isolant (14,31), dans lequel est produite pour améliorer la formation de germes sur le domaine isolant (14,31) une couche de nitrure de silicium (28,32), par laquelle, pour un dépôt de couches amorphes ou polycristallines (19,33), l'épaisseur est en général plus grande, l'homogénéité du dépôt est améliorée, la distribution de la taille des grains pour des couches polycristallines est plus uniforme et la rugosité de surface est plus faible qu'en l'absence de la couche de formation de germes (28,32), **caractérisé en ce qu'**une couche de silicium-germanium amorphe ou poiycristalline est produite comme couche semi-conductrice.

2. Procédé selon la revendication 1, **caractérisé en ce que** la couche de silicium-germanium amorphe ou polycristalline (19,33) contient du carbone ou de l'oxygène comme moyen empêchant la diffusion.

3. Procédé selon la revendication 1 ou 2, **caractérisé en ce que** la couche de nitrure de silicium (28,32) est appliquée avant une épitaxie différentielle, et la couche de silicium-germanium amorphe ou polycristalline (19,33) sur le domaine isolant (14,31) et une couche épitaxiée sur le substrat monocristallisé (11,30) sont par là produites.
